# EUROPEAN PATENT APPLICATION

(11) **EP 3 346 490 A1**
(43) Date of publication of application: **11.07.2018**
(21) Application number: 18150748.4
(22) Date of filing: 09.01.2018
(51) Int. Cl.: H01L 23/373, H01L 23/42, B82Y 30/00, C08J 5/00, C08K 7/06, C08K 7/24

(54) **ELECTRONICS THERMAL MANAGEMENT**

(30) Priority: 09.01.2017 US 201715401872
(71) Applicant: Hamilton Sundstrand Corporation, Charlotte, NC 28217-4578 (US)
(72) Inventor: HUSS, John, Roscoe, IL 61073 (US); KASNER, Alan, Long Grove, IL 60047 (US); METZLER, Mark W., Davis, IL 61019 (US); THOMPSON, Ernest, Janesville, WI 53546 (US); PAL, Debabrata, Hoffman Estates, IL 60192 (US); SHEPARD, Charles Patrick, DeKalb, IL 60115 (US)
(74) Representative: Dehns

(57) **Abstract**

Potted electronic assemblies are disclosed along with methods of making and cooling them. The electronic assemblies include a conductive heat transfer medium disposed between and in contact with an electronic component (20) and a heat sink. The conductive heat transfer medium has a hardened fluid polymer material that includes boron nitride nanotubes dispersed therein.

## Description

### BACKGROUND

Electronic components are commonly used in a wide variety of applications in a wide variety of environments. In many cases, electronic components are configured or are disposed with other components configured to remove heat generated by the electronic components during operation.

Heat-generating electronic components are designed to operate at a normal operating temperature or within a normal operating temperature range. However, if the rate of removal of heat from the device is less than the rate of heat generated by the device plus any added heat, the device can be subject to temperatures above normal operating temperature. Excessive temperatures can adversely affect the performance of the electronic component and any associated devices.

To address these issues, heat can be removed by the transfer of heat from the electronic component to a heat sink. Transfer of heat from the electronic component to the heat sink can be by various techniques, including convection, radiation, or conduction. In many cases, however, convection and radiative heat transfer are not readily available for electronic components because of factors such as the electronic component's integration within a protective housing that interferes with convective flow paths or line of sight connection to lower temperature heat sinks. One technique to increase heat transfer away from an electronic component is by thermal conduction to a heat sink structure, which can transfer heat by radiative means (e.g., through a larger surface area than that of the electronic component) or convective means. In such cases, a thermal interface material such as a thermal grease or a thermal pad/sealant provides a conductive pathway for heat transfer to the heat sink. Thermal interface materials are known to include thermally conductive fillers to promote thermal conductivity of the material. However, the use of thermally conductive fillers can be subject to problems and limitations such as limits on achievable thermal conductivity, beyond which the inclusion of additional filler loading is subject to diminished or adverse effectiveness for thermal conductivity, or adverse impacts of greater filler loadings on the properties or processability of the thermal interface material.

Another factor that can interfere with the transferring of heat from an electronic component is the presence of protective materials on the electronic component. For example, electronic components can be potted or otherwise encapsulated in or coated by a polymer material, and such polymer materials can present a thermal barrier to removal of heat from the electronic component. Attempts have been made to mitigate this thermal barrier effect by the inclusion of thermally conductive fillers in potting compositions, but loading levels of the fillers in potting compositions has been limited by adverse impacts on product performance and processability at higher loading levels.

### BRIEF DESCRIPTION

According to some embodiments, a method of making an assembly that includes an electronic component comprises disposing the electronic component proximate to a second component configured as a heat sink. A conductive heat transfer medium is disposed between the electronic component and the heat sink in contact with each of the electronic component and the heat sink by dispensing a fluid polymer material including boron nitride nanotubes dispersed therein between the electronic component and the heat sink in contact with each of the electronic component and the heat sink, and hardening the fluid polymer material.

According to some embodiments, a method of cooling an electronic component comprises disposing the electronic component proximate to a heat sink, and disposing a conductive heat transfer medium between the electronic component and the heat sink in contact with each of the electronic component and the heat sink by dispensing a fluid polymer material including boron nitride nanotubes dispersed therein between the electronic component and the heat sink in contact with each of the electronic component and the heat sink, and hardening the fluid polymer material.

According to some embodiments, a potted electronic assembly comprises an electronic component and a heat sink. A conductive heat transfer medium is disposed between the electronic component and the heat sink in contact with each of the electronic component and the heat sink. The conductive heat transfer medium comprises a hardened fluid polymer material including boron nitride nanotubes dispersed therein between the electronic component and the heat sink in contact with each of the electronic component and the heat sink.

### BRIEF DESCRIPTION OF THE DRAWINGS

Subject matter of this disclosure is particularly pointed out and distinctly claimed in the claims at the conclusion of the specification. The foregoing and other features, and advantages of the present disclosure are apparent from the following detailed description taken in conjunction with the accompanying drawings in which:
FIG. 1 schematically shows an example embodiment of an electronic assembly utilizing a fluid polymer conductive heat transfer medium in a first stage of fabrication;
FIG. 2 schematically shows an example embodiment of an electronic assembly utilizing a fluid polymer conductive heat transfer medium in a second stage of fabrication; and
FIG. 3 schematically shows an example embodiment of an electronic assembly utilizing a fluid polymer conductive heat transfer medium in a third stage of fabrication.

### DETAILED DESCRIPTION

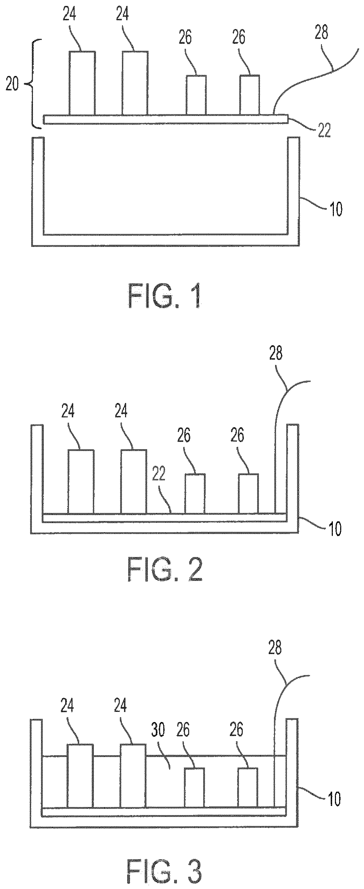

With respect to the Figures, FIGS. 1, 2, and 3 provide a schematic depiction of an example embodiment in which a fluid polymer material is disposed between an electronic component and a heat sink, and is hardened, also known as potting. FIG. 1 shows a housing 10 and an electronic component 20. The housing 10 is shown as a cross-section of a housing with a bottom and four sides, but any configuration of housing capable of retaining the electronic component(s) and the polymer material can be used. In some embodiments, the housing includes retaining surfaces in at least two dimensions, such as the bottom and side dimensions of the housing 10. In some embodiment, the housing includes a bottom wall, a sidewall enclosure and an opening for introducing the fluid polymer composition. The electronic component 20 can be any sort of electronic component, connection, or circuit, or a collection of multiple electronic components. By way of illustrative example, the electronic component as shown in FIGS. 1-3 can include a circuit board 22 with connected electronic components 24, 26 and connector lead 28. In some embodiments, connector lead 28 can provide power to the circuit board 22 with connected electronic components 24, 26. In some embodiments connector lead 28 can provide power and signal connections to the circuit board 22 with connected electronic components 24, 26. Examples of electronic components 24 or other electronic components that can be potted can include but are not limited to such as semiconductor devices, transistors, integrated circuits (IC), discrete devices, light emitting diodes (LED), inductors, transformers, capacitors, etc.

In FIG. 2 the circuit board 22 is disposed into the housing 10 as shown. In FIG. 3, a fluid polymer material 30 is introduced to the housing 10. In some embodiments, the fluid polymer material 30 can partially encase the electronic components, as shown in FIG. 3 for electronic components 24. In some embodiments, the fluid polymer material can completely encase the electronic components as shown in FIG. 3 for electronic components 26. In some embodiments, the fluid polymer material can fill the housing 10 as shown FIG. 3. In some embodiments (not shown), the fluid polymer material can be dispensed locally or discretely onto one or more electronic components without complete filling of the surrounding space. In the embodiments shown in FIGS. 1-3, the walls of the housing 10 can serve as a heat sink, which can be cooled by convection or radiative heat removal to the outside of the housing 10.

Examples of fluid polymer materials for potting can include silicones, polyurethanes (single-part or two-part), or epoxy resins (single part or two part). Hybrid polymers (e.g., siliconized urethanes or siliconized epoxies) or polymer blends can also be used. Although thermoplastics or solvent-based casting polymer compositions can be used, thermoset resins are more commonly used as they can provide dimensional stability during the curing process (compared to some solvent-based polymer casting compositions) and mild conditions to which the electronic components are subjected (compared to some thermoplastics). Thermoset fluid polymer materials can be hardened by curing conditions that can include exposure to ambient air, exposure to radiation such as visible light, UV light, or electron beam. In the case of two part curable polymer compositions, simple passage of time after combining the curable parts will promote curing and hardening of the polymer material. The fluid polymer material can be dispensed around the electronic components component 20 or portions thereof by various techniques and equipment, including pouring, spraying, jet coating, nozzle extrusion, or others. The particular dispensing technique and application settings are of course dependent on the particulars of the fluid polymer material, as will be appreciated by the skilled person.

Boron nitride nanotubes can be synthesized by known techniques, and are commercially available. Examples of techniques for making boron nitride nanotubes include arc-discharge, laser ablation, chemical vapor deposition, the pressurized vapor/condenser method, or ball milling of amorphous boron mixed with an iron powder catalyst under NH₃ atmosphere followed by subsequent annealing at about 1100 °C under nitrogen atmosphere. The boron nitride nanotubes as well as other additive materials to the fluid polymer material can be dispersed into the fluid polymer material by various mixing operations, which can be particular to the type of polymer material involved. Direct mixing or masterbatch mixing techniques can be used. In some embodiments, the amount of boron nitride nanotubes in the fluid polymer material can be in a range with a low end of >0 wt.%, 0.1 wt.%, 0.2 wt.%, or 0.3 wt.%, and a high end of 20 wt.%, 10 wt.%, 5 wt.%, 4 wt.%, 3 wt.%, 2 wt.%, or 1 wt.%, based on total weight of the fluid polymer material including the boron nitride nanotubes and any other dispersed or dissolved components. All possible combinations of the above-mentioned range endpoints (excluding impossible combinations where a low endpoint would have a greater value than a high endpoint) are explicitly included herein as disclosed ranges. In some embodiments, the fluid polymer material can have a viscosity at fabrication temperature that allows for flow of the material into contact with the heat sink and the electronic component(s). In some embodiments, heat can be applied during fabrication to promote flowability of the fluid polymer material. All possible combinations of the above-mentioned range endpoints (excluding impossible combinations where a low endpoint would have a greater value than a high endpoint) are explicitly included herein as disclosed ranges. In some embodiments, the fluid polymer material can include other components, including but not limited to boron nitride in forms other than nanotubes (e.g., 2D particles such as flakes or 3D particles such as spherical particles) with particle sizes expressed as mean diameter ranging from 300 nm to 600 nm. In some embodiments, the amount of boron nitride in the fluid polymer material in forms other than nanotubes can be in a range with a low end of 10 wt.%, 18 wt.%, or 20 wt.%, and a high end of 40 wt.%, 30 wt.%, or 20 wt.%, based on the total weight of boron nitride and fluid polymer material. All possible combinations of the above-mentioned range endpoints (excluding impossible combinations where a low endpoint would have a greater value than a high endpoint) are explicitly included herein as disclosed ranges. In some embodiments, the hardened fluid polymer material can have a thermal conductivity in a range with a low end of point of 1 W/m·K, 3 W/m·K, or 4 W/m·K, and a high end of 32 W/m·K, 30 W/m·K, or 28 W/m·K. All possible combinations of the above-mentioned range endpoints (excluding impossible combinations where a low endpoint would have a greater value than a high endpoint) are explicitly included herein as disclosed ranges.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions or equivalent arrangements not heretofore described, but which are commensurate with the spirit and scope of the present disclosure. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

## Claims

1. A method of making an assembly that includes an electronic component (20), the method comprising
disposing the electronic component (20) proximate to a second component (24, 26) configured as a heat sink;
disposing a conductive heat transfer medium between the electronic component (20) and the heat sink in contact with each of the electronic component (20) and the heat sink by dispensing a fluid polymer material including boron nitride nanotubes in an amount less than or equal to 20 wt.% dispersed therein between the electronic component (20) and the heat sink in contact with each of the electronic component and the heat sink; and
hardening the fluid polymer material.

2. The method of claim 1, wherein the fluid polymer material at least partially encapsulates the electronic component (20).

3. The method of claim 1, wherein the fluid polymer material fully encapsulates the electronic component (20).

4. The method any of the preceding claims, wherein the fluid polymer material comprises a polyurethane, a silicone, or an epoxy resin.

5. The method of any of the preceding claims, wherein the electronic component (20) is disposed in a housing (10), and the heat sink comprises a structure of said housing (10).

6. The method of claim 5, wherein the heat sink comprises a housing external wall.

7. The method of claims 5 or 6, wherein the fluid polymer material fills an enclosed portion of the housing (10).

8. The method of any of the preceding claims, wherein the fluid polymer material further comprises boron particles in spherical or flake form.

9. A potted electronic assembly, comprising
an electronic component (20);
a heat sink; and
a conductive heat transfer medium between the electronic component (20) and the heat sink in contact with each of the electronic component and the heat sink, said conductive heat transfer medium comprising a hardened fluid polymer material including boron nitride nanotubes in an amount less than or equal to 20 wt.% dispersed therein between the electronic component and the heat sink in contact with each of the electronic component and the heat sink.

10. The assembly of claim 9, wherein the hardened fluid polymer material at least partially encapsulates the electronic component (20).

11. The assembly of claim 9, wherein the hardened fluid polymer material fully encapsulates the electronic component (20).

12. The assembly any of claims 9-11, wherein the hardened fluid polymer material comprises a polyurethane, a silicone, or an epoxy resin.

13. The assembly of any of claims 9-12, wherein the electronic component (20) is disposed in a housing (10), and the heat sink comprises a structure of said housing (10), preferably a housing external wall.

14. The assembly of claim 13, wherein the hardened fluid polymer material fills an enclosed portion of the housing (10).

15. The assembly of any of claims 9-14, wherein the hardened fluid polymer material further comprises boron particles in spherical or flake form.
